# EUROPÄISCHE PATENTSCHRIFT

(11) **EP 1 227 019 B1**
(45) Veröffentlichungstag und Bekanntmachung des Hinweises auf die Patenterteilung: **20.06.2007**
(21) Anmeldenummer: 01128200.1
(22) Anmeldetag: 28.11.2001
(51) Int. Cl.: B60T 8/88, B60T 17/22, B60Q 11/00, G01R 31/00, G01P 3/481

(54) **Verfahren zur Ansteuerung einer Warnlampe bei einem Antiblockiersystem für Strassenfahrzeuge**
Method for controlling of a warning lamp for an antilock system for vehicles
Procédé de commande pour une lampe témoin d' un système antiblocage pour véhicules

(30) Priorität: 30.01.2001 DE 10103853
(43) Veröffentlichungstag der Anmeldung: 31.07.2002
(73) Patentinhaber: WABCO GmbH, 30453 Hannover (DE)
(72) Erfinder: Holst, Hans, 30926 Velber (DE)
(74) Vertreter: Schrödter, Manfred

(56) Entgegenhaltungen:
- DE-A- 3 830 278
- DE-A- 4 106 704
- US-B1- 6 170 923

## Beschreibung

Die Erfindung bezieht sich auf ein Verfahren zur Ansteuerung einer Warnlampe bei einem Antiblockiersystem (ABS) für Straßenfahrzeuge gemäß dem Oberbegriff des Patentanspruchs 1.

Eine derartige Warnlampen-Ansteuerung ist aus der DE-A1 41 067 04 bekannt. Bei der bekannten Warnlampen-Ansteuerung geht mit Einschalten der Zündung des Fahrzeugs die ABS-Fehlerlampe bzw. Warnlampe zunächst an. Daraufhin wird im Stand die Verkabelung des ABS sowie weitere Hardware geprüft. Falls diese Prüfung keine Fehler ergibt, geht die Fehlerlampe wieder aus, ansonsten bleibt sie an, und der Fehler wird in einem Fehlerspeicher des ABS gespeichert.

Anschließend werden während der Fahrt des Fahrzeugs, d. h. bei einer Fahrzeuggeschwindigkeit größer als einer Grenzgeschwindigkeit, die Radgeschwindigkeitssensoren auf korrekte Funktion bzw. Spannungsabgabe überprüft. Falls diese Überprüfung keinen Fehler ergibt, bleibt die Fehlerlampe aus. Falls jedoch ein Fehler festgestellt wird, geht die Lampe wieder an und der Fehler wird in einem Fehlerspeicher des ABS gespeichert. Dies gilt auch für weitere während der Fahrt erkannte Fehler, einschließlich Hardwarefehler und Wackelkontakte.

Falls beim Start des Fahrzeuges in der ABS-Elektronik noch ein alter Sensorfehler, d. h. ein Fehler aus einem vorherigen Betriebszyklus, gespeichert war, bleibt die Lampe nach der Verkabelungsprüfung an. In diesem Fall wird abgewartet, was die erneute Sensorprüfung während der Fahrt ergibt. Falls diesmal der betreffende Sensor als fehlerfrei erkannt wird, geht die Fehlerlampe aus, und der betreffende Fehlerspeicher wird gelöscht.

Das oben beschriebene Antiblockiersystem (ABS) ist in zwei Ausführungen hinsichtlich seiner Spannungsversorgung gebräuchlich.

Zum einen wird die Spannungsversorgung mit dem Zündschalter des Fahrzeugs ein- und ausgeschaltet, das ABS ist also während der gesamten Betriebszeit des Fahrzeuges in Funktion (Permanentversorgung).

Zum anderen sind aber auch ABS bekannt, bei denen die Spannungsversorgung über den Bremslichtschalter (direkt oder indirekt) des Fahrzeugs erfolgt. Solche Systeme sind nur dann in Betrieb, wenn der Fahrer das Bremspedal getreten hat und somit das ABS seiner Aufgabe, die Bremsung zu überwachen und gegebenenfalls zu regulieren, nachkommen muß.

Die letztgenannten Antiblockiersysteme weisen deshalb einen geringeren Stromverbrauch auf, insbesondere verbrauchen sie keinen Strom, wenn das Fahrzeug mit eingeschalteter Zündung steht. Außerdem benötigen sie, falls im Anhänger angeordnet, keine eigene Stromversorgungsleitung vom Zugfahrzeug. Andererseits ist aber bei bremslichtversorgten Systemen die Fehlererkennung, insbesondere der Radgeschwindigkeitssensoren, schwieriger, da sie jeweils nur kurz, nämlich während der eigentlichen Bremsphasen, eingeschaltet sind und Fehlerprüfungen durchführen können. Dieses Problem, wie auch die damit zusammenhängende Ansteuerung der Sensor- bzw. ABS-Warnlampe, wird weiter unten noch genauer behandelt.

Der Erfindung liegt die Aufgabe zugrunde, ein Verfahren zur Ansteuerung einer ABS-Warnlampe, insbesondere für die Funktionskontrolle der Radgeschwindigkeitssensoren, bei einem Antiblockiersystem für Straßenfahrzeuge anzugeben. Hierdurch soll dem Fahrer in genauerer Weise als beim Stand der Technik das Vorliegen bzw. das Entfallen eines Fehlers eines Radgeschwindigkeitssensors gemeldet werden.

Diese Aufgabe wird durch die im Patentanspruch 1 enthaltene Erfindung gelöst. Die Unteransprüche enthalten zweckmäßige Weiterbildungen.

Die Erfindung wird im folgenden anhand einer Zeichnung näher erläutert.

Die Zeichnung zeigt in
- Fig. 1: ein schematisches elektrisches Blockschaltbild eines ABS mit Bremslicht-Versorgung;
- Fig. 2a: ein Sensorsignal unterhalb der Ansprechschwelle;
- Fig. 2b: ein Sensorsignal oberhalb der Ansprechschwelle;
- Fig. 3: ein im ABS gebildetes Geschwindigkeitssignal eines fehlerfreien sowie eines gestörten Sensors;
- Fig. 4: ein Geschwindigkeitssignal eines Fahrzeugs mit bremslichtversorgtem ABS während einer typischen Bremsung;
- Fig. 5a: die Warnlampenansteuerung zu Fig. 4 gemäß Stand der Technik bei fehlerhaftem Sensor;
- Fig. 5b: die Warnlampenansteuerung zu Fig. 4 gemäß dem erfindungsgemäßen Verfahren bei fehlerhaftem Sensor;
- Fig. 5c: die Warnlampenansteuerung zu Fig. 4 gemäß dem erfindungsgemäßen Verfahren bei fehlerfreiem Sensor

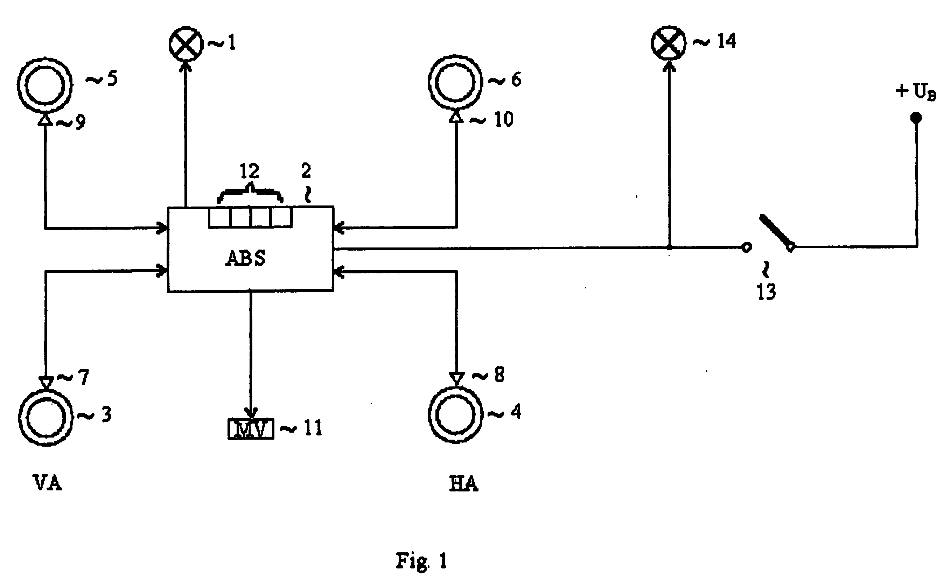

In der Fig. 1 ist als Ausführungsbeispiel in schematischer, vereinfachter Darstellung ein Antiblockiersystem (ABS) bei einem zweiachsigen Fahrzeug (Vorderachse VA, Hinterachse HA) dargestellt, welches über einen Bremslichtschalter (13) mit Betriebsspannung (U_{B}) versorgt wird. Dabei kann es sich um ein Zugfahrzeug oder um einen Anhänger handeln. Der Bremslichtschalter (13) ist in bekannter Weise mit dem Bremspedal des Zugfahrzeugs (nicht dargestellt) verbunden und dient weiter zur Ansteuerung der Bremslichter (14). Das Antiblockiersystem (ABS) (2) empfängt Geschwindigkeitssignale der Räder (3 bis 6) von an den Rädern angebrachten Raddrehzahlsensoren (7 bis 10). In an sich bekannter Weise werden die Raddrehzahlen durch das ABS überwacht und bei Blockier-Tendenz gegebenenfalls der vom Fahrer vorgegebene Bremsdruck mittels Magnetventilen (MV) (11) reguliert bzw. herabgesetzt.

Statt bei einem zweiachsigen Fahrzeug kann das Verfahren entsprechend auch bei mehrachsigen Fahrzeugen oder einachsigen Fahrzeugen (Hängern) angewendet werden.

Das ABS enthält weiter Schaltungsteile, welche speziell zur Überwachung der oben genannten Drehzahlsensoren (7 bis 10) dienen. Falls ein Drehzahlsensor als fehlerhaft erkannt worden ist, wird eine ABS-Warnlampe (1) angesteuert und der Fehler bzw. ein Sensor-Fehlerbit in einem Fehlerspeicher (12) gespeichert. Dieser enthält für jedes der vier Räder einen gesonderten Speicherplatz. Damit ist es möglich, bei späteren Reparaturen den fehlerhaften Sensor zu lokalisieren.

Die verwendeten Radgeschwindigkeitssensoren (7 bis 10) sind hier als induktive Sensoren ausgebildet, die einem am Rad befindlichen Zahnkranz gegenüberliegen (siehe z. B. DE-A1 36 28 585). Derartige, passive Sensoren geben ein Geschwindigkeitssignal ab, dessen Frequenz proportional zur Raddrehzahl und dessen Amplitude ebenfalls proportional zur Raddrehzahl sowie etwa umgekehrt proportional zum Abstand (Luftspalt) zwischen Sensor und Zahnkranz ist.

Es sind jedoch auch andere Sensoren (Hallsensoren) bekannt.

Im folgenden wird unter Sensor die Kombination Sensor-Polrad bzw. Zahnkreuz verstanden.

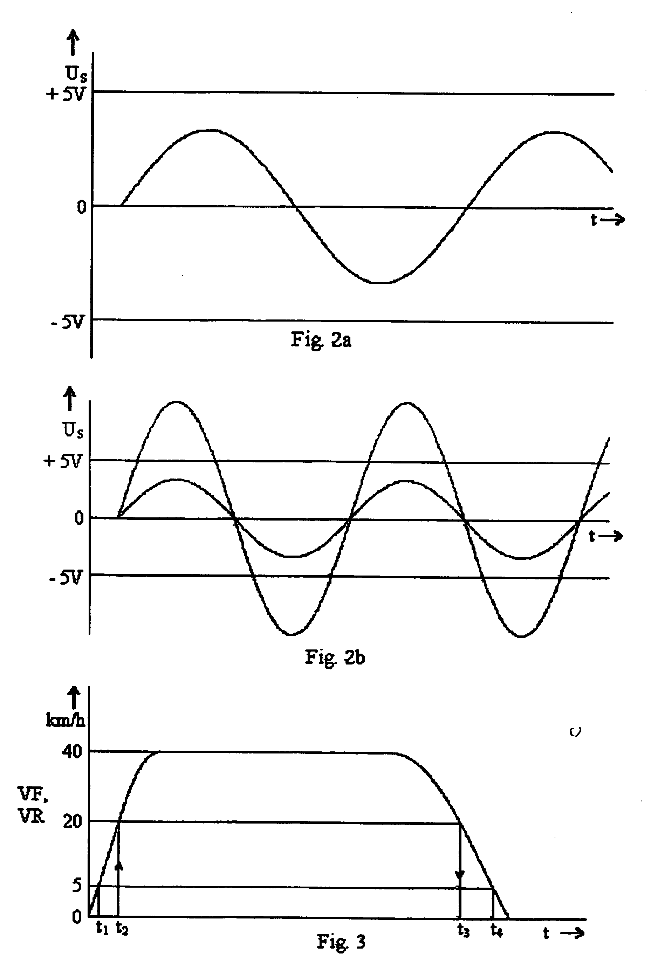

Ein von einer derartigen Kombination geliefertes Radgeschwindigkeits-Sensorsignal ist in der Fig. 2a dargestellt. Dieses ist jedoch in der Amplitude so gering, daß es eine Elektronik-interne Spannungsschwelle von hier beispielsweise ±5 Volt nicht erreicht. Die genannte Spannungsschwelle ist nötig, damit die Elektronik das Signal des Radgeschwindigkeitssensors von Störspannungen unterscheiden kann. Aus diesem Grund erkennt die ABS-Elektronik (2) das Geschwindigkeitssignal der Fig. 2a entweder als "Geschwindigkeit Null" oder als "kein Geschwindigkeitssignal vorhanden".

In der Fig. 2b ist das Ausgangssignal desselben Sensors für eine höhere Radgeschwindigkeit dargestellt. Das Signal A des ungestörten Sensors hat eine höhere Frequenz und übersteigt jetzt in der Amplitude die Spannungsgrenze von ±5 Volt. Es wird deshalb als Radgeschwindigkeit erkannt. Die ABS-Elektronik (2) wertet die Frequenz des Signales aus und rechnet diese in die Radgeschwindigkeit um.

In der Fig. 2b ist gleichzeitig eine weitere Spannungskurve B eingezeichnet, die bei der gleichen Radgeschwindigkeit erzeugt wurde, aber von einem gestörten Sensor. Die Störung liegt in diesem Fall darin, daß der Abstand (Luftspalt) zwischen Zahnkranz und Sensor unzulässig hoch ist. Aus diesem Grund ist die Spannungsabgabe des Sensors so gering, daß die obengenannte Schwelle nicht erreicht wird. Wie im Fall der Fig. 2a ist hier ebenfalls keine eindeutige Radgeschwindigkeit für die Elektronik erkennbar. Der Sensor wird deshalb als fehlerhaft erkannt.

Der oben besprochene Radgeschwindigkeitssensor ist üblicherweise mittels einer Sensor-Klemmbuchse (siehe z. B. DE-A1 32 29 207) am Chassis des Fahrzeugs befestigt und somit verschiebbar. Z. B. durch extreme Belastungen einer Fahrzeugachse oder durch zwischen Zahnkranz und Sensor geratene Fremdkörper kann es vorkommen, daß sich der Radsensor zurückschiebt und somit einen zu großen Luftspalt erhält, was zu einer Störung wie in der Fig. 2b, Kurve B, dargestellt, führt.

In der Fig. 3 ist ein innerhalb des ABS gebildetes Geschwindigkeitssignal für ein Rad dargestellt, und zwar für einen fehlerfreien sowie für einen gestörten Sensor.

Im fehlerfreien Fall übersteigt das sinusförmige Sensorsignal im Zeitpunkt t₁ die o. g. ±5 Volt-Schwelle, welche hier einer Fahrzeuggeschwindigkeit (V_{F}) von 5 km/h entspricht. Ab dem Zeitpunkt t₁ liegt also der Elektronik ein korrektes Geschwindigkeitssignal vor. Dieses steigt gemäß einer angenommenen Fahrzeugbeschleunigung bis zu einem Wert von 40 km/h an. Nach einer Fahrstrecke mit konstanter Geschwindigkeit wird das Fahrzeug wieder abgebremst. Zum Zeitpunkt t₄ unterschreitet die Amplitude des Sensorsignals wiederum die obengenannte Schwelle, so daß ab hier kein Geschwindigkeitssignal mehr vorliegt.

Im gestörten Fall, also bei einem Sensor mit unzulässig erhöhtem Luftspalt, überschreitet die Amplitude des Sensorsignals erst im Zeitpunkt t₂ die ±5 Volt-Schwelle und wird damit von der Elektronik als Geschwindigkeitssignal erkannt. Diese berechnet anschließend aus der Frequenz des Sensorsignal eine Radgeschwindigkeit von hier 20 km/h. Dieses Ansteigen der Radgeschwindigkeit von 0 auf 20 km/h bei t₂ ist physikalisch nicht möglich und wird von der Elektronik als Geschwindigkeitshochsprung erkannt. Für den entsprechenden Sensor wird ein Fehlerbit im Fehlerspeicher (12) abgelegt. Eine ordnungsgemäße ABS-Regelung für dieses Rad ist daher im Bereich von 0 bis 20 km/h nicht möglich. Ein entsprechender Vorgang ergibt sich zum Zeitpunkt t₃, wo die Radgeschwindigkeit scheinbar von 20 km/h auf 0 herabspringt. Ein solches unzulässiges Verhalten wird ebenfalls als Fehler im Fehlerspeicher (12) gespeichert.

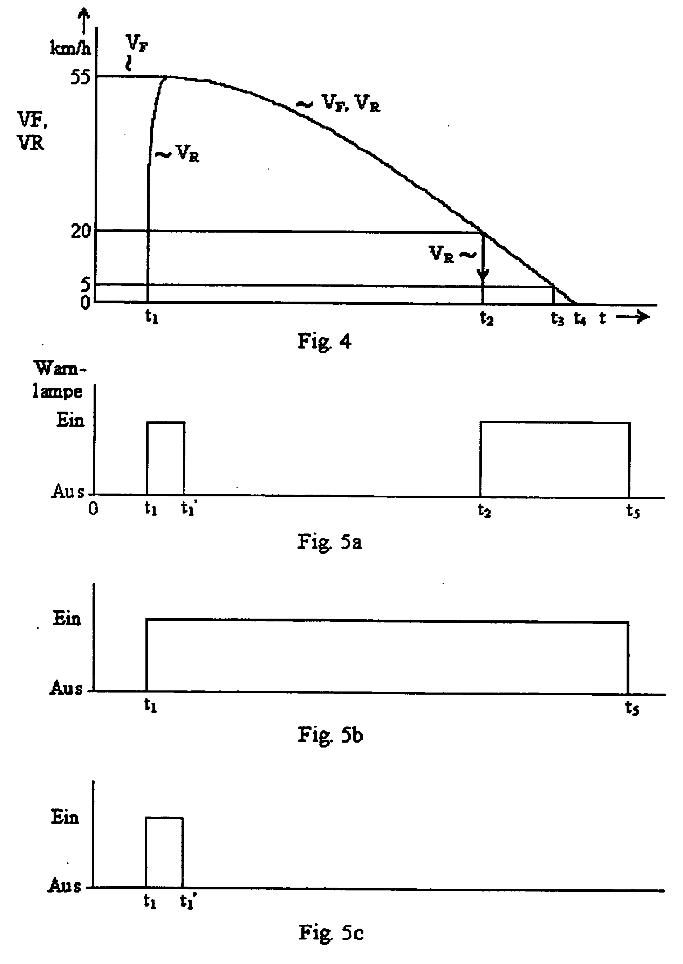

In der Fig. 4 sind Geschwindigkeiten eines Fahrzeugs (V_{F} = Fahrzeuggeschwindigkeit, V_{R} = Radgeschwindigkeit), welches mit einem bremslichtversorgten ABS ausgerüstet ist, während eines typischen Bremsvorganges über der Zeit dargestellt.

Während der Zeit 0 bis t₁ fährt das Fahrzeug mit einer konstanten Fahrzeuggeschwindigkeit (V_{F}) von hier 55 km/h. Zum Zeitpunkt t₁ betätigt der Fahrer die Bremse, gleichzeitig wird das ABS über den Bremslichtschalter (13) mit seiner Betriebsspannung U_{B} versorgt und bildet intern eine Radgeschwindigkeit V_{R}, welche hier korrekterweise von Null auf die Fahrzeuggeschwindigkeit V_{F} hochspringt. Das Fahrzeug wird im folgenden kontinuierlich gebremst, bis es im Zeitpunkt t₄ zum Stillstand kommt.

In der Fig. 5a ist die Ansteuerung der ABS-Warnlampe zu Fig. 4 gemäß dem Stand der Technik dargestellt. Dabei wird hier zunächst vorausgesetzt, daß der das Radgeschwindigkeitssignal V_{R} liefernde Sensor im Sinne der Fig. 2b, Kurve B, gestört ist, also insbesondere einen zu großen Luftspalt aufweist. Der so gestörte Sensor erzeugt deshalb in der Elektronik scheinbare Geschwindigkeitssprünge bei einer Fahrzeuggeschwindigkeit von 20 km/h. Von 0 bis t₁ ist die Warnlampe aus, da auch diese über das Bremspedal versorgt wird. Im Zeitpunkt t₁ geht die Warnlampe zunächst bis zum Zeitpunkt t_{1'} an, um dem Fahrer die ABS-Funktion anzuzeigen. Anschließend geht sie aber wieder aus, da der gestörte Sensor bei der über 20 km/h liegenden Fahrzeuggeschwindigkeit ein Signal liefert, und so nicht als gestört erkannt wird.

Ab dem Zeitpunkt t₂ erkennt dann die Elektronik einen Geschwindigkeitsabwärtssprung, was als Fehler gespeichert und durch die Warnlampe (1) angezeigt wird (EIN). Der Inhalt des entsprechenden Fehlerspeichers (12) bleibt anschließend auch bei abgeschalteter Betriebsspannung erhalten. Ab dem Zeitpunkt t₅ geht die Lampe wieder aus, da hier der Fahrer den Fuß von der Bremse nimmt.

In der Fig. 5b ist die entsprechende Warnlampenansteuerung zu Fig. 4 gemäß dem erfindungsgemäßen Verfahren bei ebenfalls fehlerbehaftetem Sensor dargestellt. Wie man erkennt, bleibt hier die Warnlampe (1) während der gesamten Bremsung eingeschaltet, da hier eine Ausschaltung der Warnlampe (1) bzw. die Löschung des Fehlerbits im Fehlerspeicher erst dann erfolgt, wenn der vorher als fehlerhaft erkannte Radgeschwindigkeitssensor bei einer vorgegebenen (niedrigen) Fahrzeuggrenzgeschwindigkeit ein Geschwindigkeitssignal (z. B. 5 km/h) liefert, dessen Amplitude größer als eine vorgegebene Spannungsschwelle (z.B. 5 Volt) ist. Dies leistet der gestörte Sensor jedoch nicht, da zum Zeitpunkt t₃, wo die vorgegebene niedrige Fahrzeuggrenzgeschwindigkeit (hier 5 km/h) vorliegt, kein Sensorsignal mehr erfaßt wird.

In der Fig. 5c ist die Warnlampenansteuerung zu Fig. 4 gemäß dem erfindungsgemäßen Verfahren mit einem Sensor dargestellt, der fehlerfrei ist. Wie man aus der Fig. 5c erkennt, wird die Warnlampe zur Fahrer-Information vom Zeitpunkt t₁ bis zum Zeitpunkt t_{1'} angesteuert.

Es hat sich in Versuchen herausgestellt, daß die vorgegebene niedrige Fahrzeuggrenzgeschwindigkeit vorteilhaft unter 20 km/h liegt. Ebenso liegt die vorgegebene Spannungsschwelle vorteilhaft unter 15 Volt.

Es ist vorteilhaft möglich, je nach gewünschtem Aufwand, für jedes sensierte Rad, oder nur für jede sensierte Achse, für jede Fahrzeugseite, oder auch nur für das Gesamtfahrzeug ein eigenes Fehlerbit zu speichern.

Das erfindungsgemäße Verfahren bietet einen besonderen Vorteil bei der ABS-Inbetriebnahme am Band oder in einer Werkstatt. Dabei sind zunächst werkseitig in dem Fehlerspeicher (12) der neuen ABS-Elektronik sämtliche Sensor-Fehlerbits gesetzt. Zur Inbetriebnahme werden dann die Räder in hochgebocktem Zustand des Fahrzeugs einzeln von Hand gedreht. Falls die ABS-Elektronik dabei ein entsprechendes Sensorsignal erkennt, werden die Sensor-Fehlerbits des gedrehten Rades gelöscht.

Beim Stand der Technik wurde nun das Sensor-Fehlerbit in jedem Fall gelöscht, sofern nur das Rad schnell genug gedreht wurde. Dabei wurden auch Sensoren mit zu großem Lufspalt als fehlerfrei angesehen.

Gemäß dem neuen Verfahren ist dies nicht mehr möglich, da jetzt nur dann ein fehlerfreier Sensor bzw. Ein fehlerfreies Sensorsignal erkannt wird, wenn eine ausreichend hohe Sensor-Amplitude bereits bei einer geringen Radgeschwindigkeit bzw. Fahrzeuggeschwindigkeit erkannt wird. Das zunächst werkseitig gespeicherte Sensor-Fehlerbit kann also auch durch schnelleres Drehen des Rades nicht mehr gelöscht werden. Statt dessen muß der von der ABS-Elektronik als fehlerhaft erkannte Sensor inspiziert werden und gegebenenfalls dessen Abstand zum Polrad (Luftspalt) von Hand auf das richtige Maß verringert werden.

Ein weiterer Vorteil des erfindungsgemäßen Verfahrens liegt darin, daß der Fahrer nun auch während einer Bremsung (von t₁, bis t₂ in Fig. 5a) durch die eingeschaltete Warnlampe auf einen fehlerhaften Sensor (bzw. ein fehlerhaftes Polrad) aufmerksam gemacht wird und seine Fahrweise darauf einstellen kann.

## Patentansprüche

1. Verfahren zur Ansteuerung einer ABS-Warnlampe (1) bei einem Antiblockiersystem (ABS) für Straßenfahrzeuge (2), insbesondere einem ABS mit Spannungsversorgung (U_{B}) über einen Bremslichtschalter (13), wobei die Geschwindigkeiten der Räder (3 bis 6) von Radgeschwindigkeitssensoren (7 bis 10) erfaßt werden, und wobei die Warnlampe (1) dann angesteuert sowie ein Sensor-Fehlerbit in einem Fehlerspeicher (12) gesetzt wird, wenn mindestens einer der Radgeschwindigkeitssensoren (7 bis 10) hinsichtlich seines Spannungssignals als fehlerhaft erkannt worden ist, und wobei die Warnlampe (1) ausgeschaltet sowie das Sensor-Fehlerbit gelöscht wird, wenn der betreffende Sensor später als fehlerfrei erkannt worden ist,
**dadurch gekennzeichnet, daß**
die Ausschaltung bzw. Löschung dann erfolgt, wenn das vorher als fehlerhaft erkannte Spannungssignal noch bei einer vorgegebenen niedrigen Fahrzeuggrenzgeschwindigkeit größer als eine vorgegebene Spannungsschwelle ist.

2. Verfahren nach Anspruch 1, **dadurch gekennzeichnet, daß** die vorgegebene niedrige Fahrzeuggrenzgeschwindigkeit kleiner als 20 km/h ist.

3. Verfahren nach Anspruch 1 bis 2, **dadurch gekennzeichnet, daß** die vorgegebene Spannungsschwelle kleiner als 15 Volt ist.

4. Verfahren nach Anspruch 1 bis 3, **dadurch gekennzeichnet, daß** für jedes sensierte Rad (3 bis 6) ein gesondertes Sensor-Fehlerbit speicherbar ist.

5. Verfahren nach Anspruch 1 bis 3, **dadurch gekennzeichnet, daß** für jede sensierte Achse (VA, HA) ein gesondertes Sensor-Fehlerbit speicherbar ist.

6. Verfahren nach Anspruch 1 bis 3, **dadurch gekennzeichnet, daß** für jede Fahrzeugseite ein gesondertes Sensor-Fehlerbit speicherbar ist.

7. Verfahren nach Anspruch 1 bis 3, **dadurch gekennzeichnet, daß** für das gesamte Fahrzeug nur ein Sensor-Fehlerbit speicherbar ist.

## Claims

1. Method for the actuation control of an ABS warning light (1) in the case of an anti-lock braking system (ABS) for road vehicles (2), especially an ABS having voltage supply (U_{B}) by way of a brake-light switch (13), the speeds of the wheels (3 to 6) being detected by wheel speed sensors (7 to 10), and the warning light (1) being actuated and a sensor error bit being set in an error memory (12) if at least one of the wheel speed sensors (7 to 10) has been recognised on the basis of its voltage signal as being defective, and the warning light (1) being switched off and the sensor error bit being cleared if the sensor in question has been recognised later as being non-defective,
**characterised in that**
the switching-off and clearing are carried out if the voltage previously recognised as being defective is still, at a pre-specified low vehicle limit speed, greater than a pre-specified voltage threshold.

2. Method according to claim 1, **characterised in that** the pre-specified low vehicle limit speed is less than 20 km/h.

3. Method according to claim 1 to 2, **characterised in that** the pre-specified voltage threshold is less than 15 volts.

4. Method according to claim 1 to 3, **characterised in that** a separate sensor error bit is arranged to be stored for each sensed wheel (3 to 6).

5. Method according to claim 1 to 3, **characterised in that** a separate sensor error bit is arranged to be stored for each sensed axle (VA, HA).

6. Method according to claim 1 to 3, **characterised in that** a separate sensor error bit is arranged to be stored for each side of the vehicle.

7. Method according to claim 1 to 3, **characterised in that** only one sensor error bit is arranged to be stored for the whole vehicle.

## Revendications

1. Procédé de commande d'une lampe témoin d'ABS (1) dans un système antiblocage (ABS) pour des véhicules (2), en particulier un ABS à alimentation en tension (U_{B}) par l'intermédiaire d'un interrupteur d'éclairage stop (13), dans lequel les vitesses des roue (3 à 6) sont détectées par des capteurs de vitesse de roue (7 à 10), et dans lequel la lampe témoin (1) est utilisée dans une mémoire d'erreur commandée comme un bit d'erreur de capteur, lorsqu'au moins un des capteurs de vitesse de roue (7 à 10) est reconnu comme défectueux par rapport à son signal de tension, et dans lequel la lampe témoin (1) est éteinte coupée comme le bit d'erreur de capteur, lorsque le capteur concerné est reconnu plus tard comme exempt d'erreur,
**caractérisé en ce que**
la coupure ou l'extinction est effectuée lorsque le signal de tension reconnu préalablement comme défectueux dans le cas d'une vitesse limite de véhicule faible prédéterminée est supérieur à un seuil de tension prédéterminé.

2. Procédé selon la revendication 1, **caractérisé en ce que** la vitesse limite de véhicule faible prédéterminée est inférieure à 20 km/h.

3. Procédé selon la revendication 1 ou 2, **caractérisé en ce que** le seuil de tension prédéterminé est inférieur à 15 V.

4. Procédé selon la revendication 1 à 3, **caractérisé en ce que**, pour chaque roue détectée (3 à 6), un bit d'erreur de capteur distinct peut être mémorisé.

5. Procédé selon la revendication 1 à 3, **caractérisé en ce que**, pour chaque essieu détecté (VA, HA), un bit d'erreur de capteur distinct peut être mémorisé.

6. Procédé selon la revendication 1 à 3, **caractérisé en ce que**, pour chaque côté du véhicule, un bit d'erreur de capteur distinct peut être mémorisé.

7. Procédé selon la revendication 1 à 3, **caractérisé en ce que**, pour l'ensemble du véhicule, un seul bit d'erreur de capteur peut être mémorisé.
